# EUROPÄISCHE PATENTSCHRIFT

(11) **EP 0 945 735 B1**
(45) Veröffentlichungstag und Bekanntmachung des Hinweises auf die Patenterteilung: **18.10.2006**
(21) Anmeldenummer: 99103386.1
(22) Anmeldetag: 22.02.1999
(51) Int. Cl.: G01R 31/316

(54) **Anordnung zum Erkennen von Kontaktfehlern beim Testen von integrierten Schaltungen**
Appliance for detecting contact faults during testing integrated circuits
Dispositif pour détecter des fautes de contact pendant le test des circuits intégrés

(30) Priorität: 26.03.1998 DE 19813503
(43) Veröffentlichungstag der Anmeldung: 29.09.1999
(73) Patentinhaber: Infineon Technologies AG, 81669 München (DE)
(72) Erfinder: Savignac, Dominique, 85737 Ismaning (DE); Wirth, Norbert, 85716 Unterschleissheim (DE); Weber, Frank, 84559 Kraiburg/Inn (DE)
(74) Vertreter: Müller - Hoffmann & Partner

(56) Entgegenhaltungen:
- EP-A- 0 745 935
- US-A- 5 565 767

## Beschreibung

Die vorliegende Erfindung betrifft eine Anordnung zum Erkennen von Kontaktfehlern beim Testen von integrierten Schaltungen mit einer Vielzahl von aus einem Gehäuse der integrierten Schaltung herausragenden Pins, die mit jeweiligen Pads auf einem Halbleiterkörper der integrierten Schaltung verbunden sind.

Integrierte Schaltungen, wie insbesondere Speicherbausteine, werden vor ihrem Einbau in ein Gerät, beispielsweise einen Personalcomputer, in einem Tester einer Prüfung hinsichtlich ihrer einwandfreien Funktionsfähigkeit unterzogen. Nun sind aber speziell bei Speicherbausteinen, wie beispielsweise SDRAMs, die meisten Kontroll-Eingänge aktiv "low", d.h. die Kontroll-Eingänge sind aktiviert, wenn an ihnen ein niedriges bzw. kein Potential anliegt.

Treten nun in einem Tester oder auch in einem "Burn-In-Ofen" Kontaktprobleme derart auf, daß nicht alle gewünschten Pins kontaktiert sind, so können sich Schaltungen von nicht-kontaktierten Pins in der integrierten Schaltung wie aktivierte Schaltungen verhalten. Speziell bei den Burn-In-Prozessen führt dies zu falschen Meßergebnissen.

Dies bedeutet aber, daß nach einem Durchlauf durch einen Tester integrierte Schaltungen fälschlicherweise als "Pass" bzw. einwandfrei eingeteilt sein können, obwohl diese integrierten Schaltungen teilweise Fehler enthalten und als "Fail" beurteilt werden müßten.

So wurden Versuche durchgeführt, bei denen von integrierten Schaltungen, bevor diese in einen Tester eingelegt wurden, Pins abgeklemmt bzw. abgebrochen wurden. Die Anschlüsse mit den abgebrochenen Pins konnten im Tester selbstverständlich nicht kontaktiert werden. Dennoch wurde eine Vielzahl solcher integrierter Schaltungen als "Pass" beurteilt, da deren Kontroll-Eingänge mit den abgebrochenen Pins aktiv "low" sind und sich somit intern im Tester wie aktiviert verhalten.

Die obigen Probleme treten verstärkt bei integrierten Schaltungen der sogenannten TSOP-Bausteine (TSOP = "Thin Small Outline Package") auf, also bei Bausteinen, die sich durch eine besonders flache Form auszeichnen. Dies ist wohl dadurch bedingt, daß mit steigender Miniaturisierung der Bausteine deren Testen immer höhere Anforderungen stellt. Zur Überwindung dieser Schwierigkeit wurde bereits daran gedacht, mögliche Kontaktprobleme im Tester dadurch zu vermeiden, daß die TSOP-Bausteine noch im "ungebogenen" Zustand getestet werden, also in den Tester eingelegt werden, bevor die Pins zugerichtet und geformt sind. Dadurch wird an sich zwar eine bessere Kontaktierung der Pins erreicht. Jedoch erfordert ein derartiges Vorgehen spezielle Sockel im Tester, was den Testvorgang letztlich kompliziert und kostenaufwendig macht. Außerdem hat sich gezeigt, daß selbst beim Testen der TSOP-Bausteine im ungebogenen Zustand der Pins Fehler auftreten können, so daß Bausteinen die Beurteilung "Pass" zugeteilt wird, obwohl diese im Tester nicht an allen gewünschten Pins kontaktiert waren.

Es ist daher Aufgabe der vorliegenden Erfindung, eine Anordnung zum Erkennen von Kontaktfehlern beim Testen von integrierten Schaltungen zu schaffen, welche die obigen Schwierigkeiten überwindet und zuverlässig garantiert, daß nur solche integrierte Schaltungen in "Pass" eingeteilt werden, die tatsächlich auf ihre Funktionsfähigkeit überprüft wurden.

Diese Aufgabe wird bei einer Anordnung der eingangs genannten Art erfindungsgemäß gelöst durch zwischen jeweiligen Pads und der integrierten Schaltung liegende Pull-Up- oder Pull-Down-Einrichtungen, die jeweils durch Einprägen eines Haltestromes die Pads auf einem hohen oder niedrigen Potential halten, falls beim Testen das zugehörige Pin nicht kontaktiert ist, so daß eine Aktivierung des mit dem Pin verbundenen Schaltungsteils vermieden ist.

Die Erfindung geht also grundsätzlich einen vom bisherigen Stand der Technik abweichenden Weg: anstelle weitere Verbesserungen am Tester selbst vorzunehmen oder Maßnahmen zu ergreifen, die die Pins zuverlässig durch den Tester kontaktieren lassen, wird das Testen von einer in die integrierte Schaltung eingebauten Pull-Up- bzw. Pull-Down-Einrichtung übernommen. So zieht eine Pull-Up-Einrichtung das Potential an nicht-kontaktierten Pins nach oben, so daß diese Pins, die an sich aktiv "low" sind, nicht mehr als aktiviert beurteilt werden. Selbst wenn also im Tester einige Pins nicht kontaktiert sind, ist gewährleistet, daß diese Pins im Potential hochgezogen werden, so daß sie beim Testvorgang aus dem aktivierten in den nicht-aktivierten Zustand übergehen, also eine Aktivierung der angeschlossenen Schaltung vermieden wird. Die Pull-Down-Einrichtung arbeitet "spiegelbildlich" zu der Pull-Up-Einrichtung: sie zieht das Potential an einem mit einem nicht-kontaktierten Pin verbundenen Pad auf einen niedrigen Wert, so daß eine Aktivierung der sonst bei hohem Potential aktivierten angeschlossenen Schaltung vermieden wird.

Bausteine, bei denen mit nicht-kontaktierten Pins verbundene Pads durch die Pull-Up- oder die Pull-Down-Einrichtung auf hohem bzw. niedrigem Potential gehalten sind, werden im Tester ohne weiteres als "Fail" erkannt, so daß die Qualität der Pass-Bausteine zuverlässig gewährleistet ist.

Die Input-Leckage-Spezifikation (Eingangs-Leckstrom-Spezifikation) von Baustein-Eingängen ist bekanntlich sehr eng und liegt derzeit bei SDRAMs in Bereich von ±1 µA gegenüber ±10 µA bei Standard-EDO-DRAMs. Ein "bleader" an jedem Input-Pad ist damit kaum möglich, weil die kundenseitig maximal tolerierten Leckströme im Bereich von 10 nA liegen. Daher ist die Pull-Up- bzw. Pull-Down-Einrichtung während des Testmodus bzw. Burn-In-Modus und/oder während der Einschaltphase des Bausteines in einem ersten aktiven Zustand, wobei ihre Stromfähigkeit so groß gewählt wird, daß ein ungewolltes Schalten von nicht-kontaktierten, mit dem betreffenden Pad verbundenen Input-Schaltungen sicher vermieden wird, ohne jedoch die Funktion des Bausteins zu stören. Im Normalbetrieb ist die Pull-Up- bzw. Pull-Down-Einrichtung entweder ganz ausgeschaltet oder in einem zweiten aktiven Zustand, wobei ihre Stromfähigkeit kleiner als im ersten Zustand und derart bemessen ist, daß die normale Funktion des Bausteins nicht beeinträchtigt wird und in einem Rechnersystem die Summe der Input-Leckage-Ströme ein vertretbares Maß nicht überschreitet.

Nachfolgend wird die Erfindung anhand der Zeichnungen näher erläutert. Es zeigen:
- Fig. 1: eine Draufsicht auf eine integrierte Schaltung bzw. einen Baustein,
- Fig. 2: eine Einzelheit des Bausteines von Fig. 1,
- Fig. 3 und 4: zwei verschiedene Ausführungsbeispiele der erfindungsgemäßen Anordnung und
- Fig. 5: den Verlauf der Spannung an mit nicht-kontaktierten Pins verbundenen Pads bei der erfindungsgemäßen Anordnung.

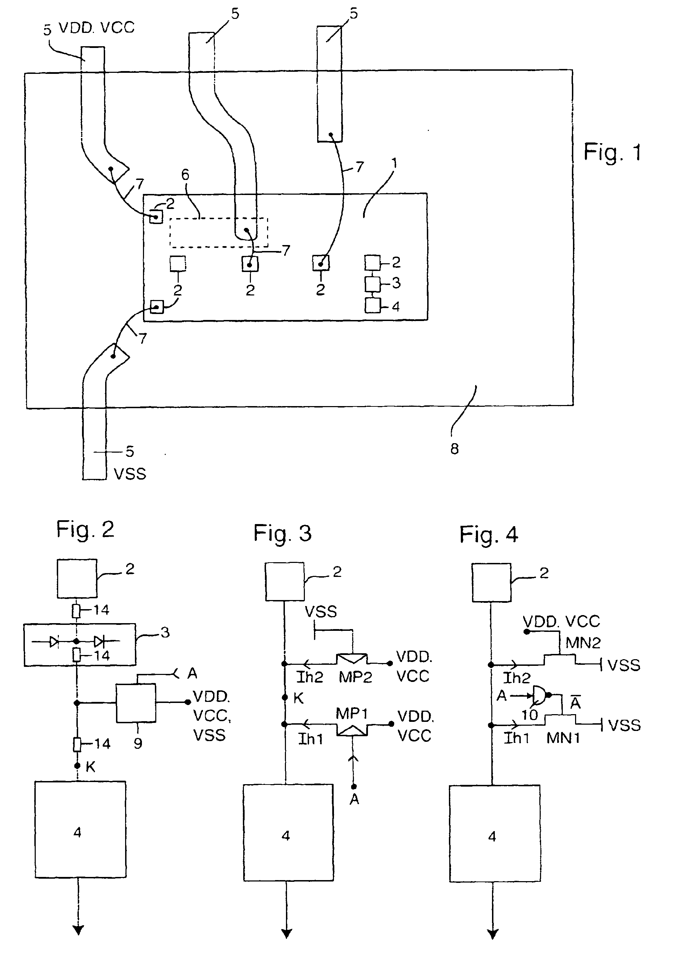

Fig. 1 zeigt in Draufsicht einen Halbleiterkörper (Silizium-Chip) 1, auf dem Pads 2 vorgesehen sind, die beispielsweise aus Aluminium bestehen und im Halbleiterkörper 1 (vgl. das in Fig. 1 rechte Pad 2) mit einer Schutzstruktur 3 und einem Eingangs- oder Eingangs/Ausgangs-Puffer 4 verbunden sind. An den Puffer 4 schließen sich in dem Halbleiterkörper 1 weitere Schaltungen an, so daß im Halbleiterkörper 1 insgesamt eine integrierte Schaltung ausgeführt ist.

Die Kontaktierung der Pads 2 erfolgt über Pins 5, die aus beispielsweise einem Standard-Leiterrahmen aus Kupfer oder in LOC-Montage (LOC = "Lead On Chip") gebildet sind. Bei der LOC-Montage ist der zu dem Pin gehörige Leiter bis auf den Halbleiterkörper 1 geführt und von diesem durch ein Klebeband 6 getrennt. Gold-Bonddrähte 7 verbinden schließlich die Leiterrahmen bzw. Pins 5 mit den Pads 2.

Über die Pins 5 werden dem Halbleiterkörper 1 bzw. der darin ausgebildeten integrierten Schaltung auch ein hohes Potential VDD bzw. VCC und ein niedriges Potential VSS zugeführt.

Der Halbleiterkörper 1 mit den Pads 2, den Bonddrähten 7 und den Enden der Pins bzw. Leiterbahnen ist schließlich in eine Kunststoffmasse 8 aus beispielsweise Epoxydharz eingehüllt.

Zur besseren Übersichtlichkeit sind in Fig. 1 lediglich einige Pins 5 gezeigt, und der Halbleiterkörper 1 sowie die Pads 2, die Bonddrähte 7, die im Halbleiterkörper 1 ausgebildete Schutzstruktur 3 und der ebenfalls im Halbleiterkörper ausgebildete Puffer 4 sind wie die innenliegenden Teile der Leiterbahnen und Pins in Vollinien dargestellt, obwohl diese Teile an sich in der gezeigten Draufsicht nicht zu sehen sind.

Ein solcher Baustein, wie er in Fig. 1 dargestellt ist (selbstverständlich mit einer sehr großen Anzahl von Pins) wird in einen Tester gelegt, in welchem die freiliegenden Enden der Pins 5 mit Testspannungen beaufschlagt werden. Da nun Speicherbausteine, wie beispielsweise SDRAMs, meist "aktiv low" Eingänge besitzen, verhalten sich im Tester mit nicht-kontaktierten Pins bzw. deren Pads 2 verbundene Schaltungen in der integrierten Schaltung wie aktivierte Schaltungen, so daß im Test mögliche Fehler nicht erkannt werden können und als "Fail" zu beurteilende integrierte Schaltungen als "Pass" eingestuft werden.

Um diese Schwierigkeit zu überwinden, ist bei der erfindungsgemäßen Anordnung eine Pull-Up- oder Pull-Down-Einrichtung 9 (vgl. Fig. 2) vorgesehen, die zwischen dem Pad 2 und der Schutzstruktur 3 aus beispielsweise Dioden oder zwischen dieser Schutzstruktur 3 und dem Puffer 4 (wie in Fig. 2 gezeigt) angeordnet sein kann. Die Pull-Up- bzw. Pull-Down-Einrichtungen 9 können dabei an der Strecke zwischen dem Pad 2 und dem Puffer 4 vor und/oder hinter fakultativ vorhandenen Widerständen 14 oder anderen Bauelementen, wie z.B. N-Well, und ggf. Knoten K angeschlossen sein. Diese Pull-Up- bzw. Pull-Down-Einrichtung 9 bewirkt, daß das zugehörige Pad 2 auf einem hohen bzw. niedrigen Potential gehalten wird, falls das zu diesem Pad 2 zugehörige Pin 5 in dem Tester nicht kontaktiert ist, so daß eine Aktivierung der mit diesem Pad 2 bzw. dem entsprechenden Puffer 4 verbundenen Schaltung zuverlässig vermieden wird.

Die Einrichtung 9 hat wenigstens drei Anschlüsse: sie erhält bei der Pull-Up-Einrichtung eine hohe Versorgungsspannung VCC bzw. VDD bzw. bei der Pull-Down-Einrichtung eine niedrige Versorgungsspannung VSS sowie bei der Pull-Up-Einrichtung und der Pull-Down-Einrichtung ein "Steuersignal" A aus der im Halbleiterkörper 1 ausgebildeten integrierten Schaltung.

Fig. 3 zeigt die Realisierung einer Pull-Up-Einrichtung: ein erster P-Kanal-MOS-Transistor MP1 liegt mit einem ersten Anschluß zwischen dem Pad 2 und dem Puffer 4 vor oder hinter der Schutzstruktur 3, die selbst Widerstände enthalten kann. Da die Anordnung bezüglich der Schutzstruktur 3 beliebig ist, ist diese in Fig. 3 weggelassen. Der andere Anschluß des MOS-Transistors MP1 liegt an hohem Potential VCC bzw. VDD. Gate des MOS-Transistors MP1 ist das Signal A zugeführt.

Gegebenenfalls kann noch ein zweiter P-Kanal-MOS-Transistor MP2 vorgesehen werden, der zwischen dem hohen Potential VDD bzw. VCC und der das Pad 2 mit dem Puffer 4 verbindenden Leitung liegt und an seinem Gate mit dem niedrigen Potential VSS beaufschlagt ist.

Fig. 4 zeigt eine Pull-Down-Einrichtung mit einem ersten N-Kanal-MOS-Transistor MN1, der zwischen dem niedrigen Potential VSS und der das Pad 2 mit dem Puffer 4 verbindenden Leitung vor oder hinter der Schutzstruktur 3 (in Fig. 4 ebenfalls nicht gezeigt) angeschlossen und an seinem Gate über einen Inverter 10 mit dem Signal A beaufschlagt ist.

Gegebenenfalls bzw. optional kann noch ein zweiter N-Kanal-MOS-Transistor MN2 ebenfalls zwischen dem niedrigen Potential VSS und der das Pad 2 mit dem Puffer 4 verbindenden Leitung vorgesehen sein. Dieser zweite MOS-Transistor MN2 ist an seinem Gate mit dem hohen Potential VDD bzw. VCC beaufschlagt.

In den Fig. 3 und 4 sind die Widerstände und Knoten der Fig. 2 aus Gründen der Übersichtlichkeit weggelassen. Sie können selbstverständlich aber auch hier vorhanden sein.

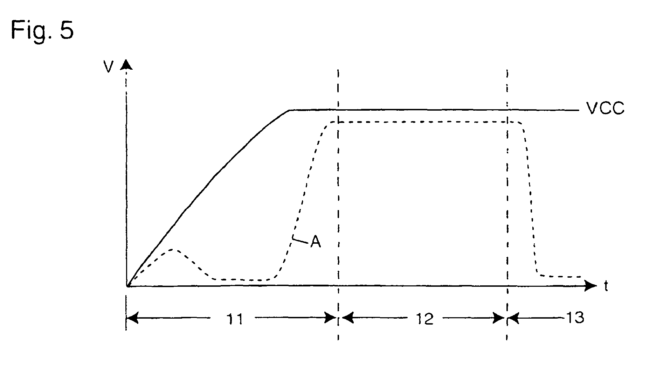

Anhand der Fig. 5 soll im folgenden der Betrieb der Pull-Up- bzw. Pull-Down-Einrichtung 9 näher erläutert werden.

Bei Anlegen der Versorgungsspannung VCC steigt diese in der "Power-Up-Phase" 11 relativ rasch an, während die Spannung A nur langsam hochgezogen wird. In diesem ersten Zustand ist also A niedrig bzw. low, was bedeutet, daß der erste P-Kanal-MOS-Transistor MP1 (Fig. 3) eingeschaltet ist. Ebenso ist der erste N-Kanal-MOS-Transistor MN1 eingeschaltet. Damit fließt sowohl in der Pull-Up-Einrichtung als auch in der Pull-Down-Einrichtung ein Haltestrom Ih1 von ungefähr 10 µA. Gleiches gilt auch für den Testmodus bzw. Burn-In-Modus 13, in welchem die Spannung A rasch abfällt. Während eines Normalbetriebes 12 ist die Spannung A hoch bzw. high, so daß der erste P-Kanal-MOS-Transistor MP1 bzw. der erste N-Kanal-MOS-Transistor MN1 jeweils ausgeschaltet ist.

Sind bei der Pull-Up-Einrichtung bzw. der Pull-Down-Einrichtung zusätzlich noch die zweiten MOS-Transistoren MP2 bzw. MN2 vorhanden, so sind im ersten Zustand (Power-Up-Phase 11, Testmodus 13) beide Transistoren MP1, MP2 bzw. MN1 und MN2 beide eingeschaltet, falls die Spannung A niedrig ist. Der Haltestrom ist dann aus der Summe der Halteströme Ih1 des Transistors MP1 bzw. MN1 und des etwa 5 nA betragenden Haltestromes des jeweiligen zweiten Transistors MP2 bzw. MN2 gegeben. Im zweiten Zustand (Normalbetrieb 12) sind die jeweiligen zweiten Transistoren MP2 bzw. MN2 eingeschaltet, während die ersten Transistoren MP1 bzw. MN1 ausgeschaltet sind. Es liegt hier dann ein Haltestrom Ih2 in der Größenordnung von 5 nA vor.

Für die jeweiligen zweiten Transistoren MP2 bzw. MN2 können gegebenenfalls auch P-Kanal-Transistoren mit minimaler GateLänge, deren Gate ebenfalls mit der hohen Spannung VCC bzw. VDD beaufschlagt ist, oder Widerstände (für Pull-Up-Einrichtung) oder N-Kanal-Transistoren mit minimaler Gatelänge, deren Gate mit VSS beaufschlagt ist, oder ebenfalls Widerstände, verwendet werden.

Die Pull-Up-Einrichtung ist besonders geeignet für Eingänge von SDRAMs wie CS, WE, CAS, RAS, U/L DQM, A0 bis 13, CLK. Dagegen ist die Pull-Down-Einrichtung besonders für den Eingang CKE bei SDRAMs vorteilhaft.

## Patentansprüche

1. Anordnung zum Erkennen von Kontaktfehlern beim Testen von integrierten Schaltungen mit einer Vielzahl von aus einem Gehäuse (8) der integrierten Schaltung herausragenden Pins (5), die mit jeweiligen Pads (2) auf einem Halbleiterkörper (1) der integrierten Schaltung verbunden sind, **gekennzeichnet durch** in der Strecke zwischen jeweiligen Pads (2) und dem Eingang der integrierten Schaltung liegende Pull-Up- oder Pull-Down-Einrichtungen (9), die jeweils **durch** Einprägen eines Haltestroms die Pads (2) auf einem hohen oder niedrigen Potential halten, falls beim Testen das zugehörige Pin (5) nicht kontaktiert ist, so daß eine Aktivierung des mit dem Pin (5) verbundenen Schaltungsteiles vermieden ist.

2. Anordnung nach Anspruch 1, **dadurch gekennzeichnet, daß** die Pull-Up-Einrichtung aus einem ersten P-Kanal-MOS-Transistor (MP1) besteht, der zwischen der das Pad (2) mit einem Eingangspuffer (4) verbindenden Strecke und einem hohen Potential (VDD, VCC) liegt und an seinem Gate mit einer Spannung (A) beaufschlagt ist.

3. Anordnung nach Anspruch 2, **dadurch gekennzeichnet, daß** die Pull-Up-Einrichtung zusätzlich einen zweiten P-Kanal-MOS-Transistor (MP2) aufweist, der zwischen der das Pad (2) mit dem Eingangspuffer (4) verbindenden Strecke und dem hohen Potential (VDD, VCC) liegt und an seinem Gate mit dem niedrigen Potential (VSS) beaufschlagt ist.

4. Anordnung nach Anspruch 1, **dadurch gekennzeichnet, daß** die Pull-Down-Einrichtung aus einem ersten N-Kanal-MOS-Transistor (MN1) besteht, der zwischen der das Pad (2) mit einem Eingangspuffer (4) verbindenden Strecke und einem niedrigen Potential (VSS) liegt und an seinem Gate mit einer invertierten Spannung (A̅) beaufschlagt ist.

5. Anordnung nach Anspruch 4, **dadurch gekennzeichnet, daß** die Pull-Down-Einrichtung außerdem einen zweiten N-Kanal-MOS-Transistor (MN2) aufweist, der zwischen der das Pad (2) mit dem Eingangspuffer (4) verbindenden Strecke und dem niedrigen Potential (VSS) liegt und an seinem Gate mit dem hohen Potential (VDD, VCC) beaufschlagt ist.

6. Anordnung nach Anspruch 2 oder 4, **gekennzeichnet durch** einen parallel zum ersten Transistor liegenden Widerstand.

7. Anordnung nach einem der Ansprüche 1 bis 6, **dadurch gekennzeichnet, daß** in der Strecke zwischen Pad (2) und dem Eingang der integrierten Schaltung vor und/oder hinter den Pull-Up- bzw. Pull-Down-Einrichtungen Widerstände (14) und/oder Knoten (K) vorgesehen sind.

## Claims

1. Arrangement for identifying contact faults during the testing of integrated circuits with a multiplicity of pins (5) which protrude from a housing (8) of the integrated circuit and are connected to respective pads (2) on a semiconductor body (1) of the integrated circuit, **characterized by** pull-up or pull-down devices (9) connected in the path between respective pads (2) and the input of the integrated circuit, which devices in each case hold the pads (2) at a high or low potential by impressing a holding current, if contact has not been made with the associated pin (5) during testing, with the result that activation of the circuit section connected to the pin (5) is avoided.

2. Arrangement according to Claim 1, **characterized in that** the pull-up device comprises a first P-channel MOS transistor (MP1), which is connected between the path lying the pad (2) to an input buffer (4) and a high potential (VDD, VCC) and has a voltage (A) applied to its gate.

3. Arrangement according to Claim 2, **characterized in that** the pull-up device additionally has a second P-channel MOS transistor (MP2), which is connected between the path connecting the pad (2) to the input buffer (4) and the high potential (VDD, VCC) and has the low potential (VSS) applied to its gate.

4. Arrangement according to Claim 1, **characterized in that** the pull-down device comprises a first N-channel MOS transistor (MN1), which is connected between the path connecting the pad (2) to an input buffer (4) and a low potential (VSS) and has an inverted voltage (*A̅*) applied to its gate.

5. Arrangement according to Claim 4, **characterized in that** the pull-down device additionally has a second N-channel MOS transistor (MN2), which is connected between the path connecting the pad (2) to the input buffer (4) and the low potential (VSS) and has the high potential (VDD, VCC) applied to its gate.

6. Arrangement according to Claim 2 or 4,
**characterized by** a resistor connected in parallel with the first transistor.

7. Arrangement according to one of Claims 1 to 6, **characterized in that** resistors (14) and/or nodes (K) are provided in the path between pad (2) and the input of the integrated circuit upstream and/or downstream of the pull-up or pull-down devices.

## Revendications

1. Dispositif de détection de mauvais contacts lorsque l'on teste des circuits intégrés ayant une pluralité de broches (5) sortant d'un boîtier (8) du circuit intégré et reliées à des plages (12) respectives de connexion sur un corps (1) semiconducteur du circuit intégré, **caractérisé par** des dispositifs (9) de mise à l'état haut ou de mise à l'état bas se trouvant dans la section comprise entre les plages (2) respectives de connexion et l'entrée du circuit intégré et maintenant respectivement par application d'un courant de maintien les plages (2) de connexion à un potentiel haut ou bas, dans le cas où, lors du test, la broche (5) associée n'est pas mise en contact, de manière à empêcher une activation de la partie du circuit reliée à la broche (5).

2. Dispositif suivant la revendication 1, **caractérisé en ce que** le dispositif de mise à l'état haut est constitué d'un premier transistor (MP) MOS à canal P, qui se trouve entre la section reliant la plage (2) de connexion à un tampon (4) d'entrée et un potentiel (VDD, VCC) haut et à la grille duquel est appliquée une tension (A).

3. Dispositif suivant la revendication 2, **caractérisé en ce que** le dispositif de mise à l'état haut a en outre un deuxième transistor (MP2) MOS à canal P, qui se trouve entre la section reliant la plage (2) de connexion au tampon (4) d'entrée et le potentiel (VDD, VCC) haut et à la grille duquel est appliqué le potentiel (VSS) bas.

4. Dispositif suivant la revendication 1, **caractérisé en ce que** le dispositif de mise à l'état bas est constitué d'un premier transistor (MN1) MOS à canal N, qui se trouve entre la section reliant la plage (2) de connexion à un tampon (4) d'entrée et un potentiel (VSS) bas et à la grille duquel est appliquée une tension (A̅) inversée.

5. Dispositif suivant la revendication 4, **caractérisé en ce que** le dispositif de mise à l'état bas a en outre un deuxième transistor (MN2) MOS à canal N, qui se trouve entre la section reliant la plage (2) de connexion au tampon (4) d'entrée et qui est son potentiel (VSS) bas et à la grille duquel est appliqué le potentiel (VDD, VCC) haut.

6. Dispositif suivant l'une des revendications 2 ou 4 **caractérisé par** une résistance montée en parallèle au premier transistor.

7. Dispositif suivant l'une des revendications 1 à 6
**caractérisé en ce qu'**il est prévu dans la section comprise entre la plage (2) de connexion et l'entrée du circuit intégré des résistances (14) et/ou des noeuds (K) devant et/ou derrière les dispositifs de mise à l'état haut ou de mise à l'état bas.
